# EUROPÄISCHE PATENTSCHRIFT

(11) **EP 0 341 576 B1**
(45) Veröffentlichungstag und Bekanntmachung des Hinweises auf die Patenterteilung: **28.06.1995**
(21) Anmeldenummer: 89108068.1
(22) Anmeldetag: 04.05.1989
(51) Int. Cl.: H03K 17/955

(54) **Selbstprüfender, kapazitiver Näherungsschalter**
Self-checking capacitive proximity switch
Interrupteur de proximité capacitif auto-contrôlé

(30) Priorität: 07.05.1988 DE 3815698
(43) Veröffentlichungstag der Anmeldung: 15.11.1989
(73) Patentinhaber: Gebhard Balluff Fabrik feinmechanischer Erzeugnisse GmbH & Co., 73765 Neuhausen (DE)
(72) Erfinder: Kammerer, Heinz, D-7302 Ostfildern 2 (DE); Dolderer, Peter, D-7302 Ostfildern 2 (DE)
(74) Vertreter: Hoeger, Stellrecht & Partner

(56) Entgegenhaltungen:
- EP-A- 0 087 094
- EP-A- 0 132 850
- DE-A- 2 739 786
- GB-A- 2 177 216

## Beschreibung

Die Erfindung betrifft einen selbstprüfenden Näherungsschalter mit einem durch Annäherung eines Gegenstandes an seine Sensorfläche beeinflußbaren Oszillator, dem ein Demodulator und eine Triggerstufe nachgeschaltet sind, mit einer kapazitiv an den Oszillator angekoppelten Prüfimpulsquelle zur Erzeugung von Prüfimpulsen, deren Amplitude ausreichend hoch ist, um bei mindestens einem Schaltzustand der Triggerstufe ein Kippen derselben in den anderen ihrer beiden Schaltzustände herbeizuführen, und mit einer auf die in Abhängigkeit von den Prüfimpulsen auftretenden Pegeländerungen des Ausgangssignals der Triggerstufe ansprechenden, der Erzeugung eines Prüfausgangssignals dienenden Prüfschaltung.

Ein selbstprüfender Näherungsschalter dieser Art, und zwar ein induktiver Näherungsschalter, ist aus der DE-OS 33 27 188 bekannt. Bei diesem bekannten, induktiven Näherungsschalter wird die Prüfimpulsquelle insbesondere kapazitiv an den Speisespannungskreis des Oszillatorverstärkers angekoppelt. Als Prüfimpulse dienen bei dem bekannten Näherungsschalter bipolare Doppelimpulse, von denen ein Einzelimpuls der einen Polarität ein Absinken der Amplitude der Oszillatorschwingung bewirkt, während der darauf folgende Einzelimpuls entgegengesetzter Polarität eine Erhöhung der Amplitude der Oszillatorschwingung bewirkt. Dabei wird die Amplitude der Prüfimpulse einerseits und die Lage der Triggerschwellen des Näherungsschalters andererseits so gewählt, daß bei bedämpftem und unbedämpftem Oszillator jeweils durch einen der Einzelimpulse jedes Doppelimpulses eine Änderung des Triggerausgangssignals herbeigeführt wird.

Ausgehend von diesem Stand der Technik liegt der Erfindung die Aufgabe zugrunde, die Fehlersicherheit eines Näherungsschalters der eingangs angegebenen Art noch weiterzuverbessern.
Diese Aufgabe wird bei einem gattungsgemäßen Näherungsschalter gemäß der Erfindung durch die im Anspruch 1 angegebenen Merkmale gelöst.

Dadurch, daß die Prüfimpulse bei dem erfindungsgemäßen Näherungsschalter am Eingang des Oszillatorverstärkers, insbesondere an der Basis des Oszillatortransistors,eingekoppelt werden, ergibt sich der wichtige Vorteil, daß auch die einwandfreie Funktion des Verstärkers bzw. des Transistors selbst überwacht wird. Dabei können die Prüfimpulse direkt an den Basisanschluß des Oszillatortransistors angelegt werden.
Besonders günstig ist es jedoch in Ausgestaltung der Erfindung, wenn die Prüfimpulsquelle mit einer zusätzlichen zweiten Elektrode verbunden ist, die in unmittelbarer Nähe der Sensorelektrode angeordnet ist. In diesem Fall können die Prüfimpulse kapazitiv über die durch die Sensorelektrode und die zusätzliche Elektrode gebildete Koppelkapazität eingekoppelt werden, wobei die Sensorelektrode direkt mit der Basis des Oszillatortransistors verbunden ist, so daß nicht nur die Funktion des Oszillatortransistors, sondern darüber hinaus auch das Vorhandensein einer einwandfreien Verbindung zwischen der Sensorelektrode und der Basis des Ozillatortransistors überwacht wird.

Das kapazitive Ankoppeln der Prüfimpulsquelle an die Basis des Oszillatortransistors bringt dabei den zusätzlichen Vorteil mit sich, daß unipolare Spannungsimpulse, welche von der Prüfimpulsquelle an die zusätzliche zweite Elektrode angelegt werden, aufgrund der Umladevorgänge in der Koppelkapazität zu bipolaren Stromimpulsen am Basisanschluß des Oszillatortransistors führen, so daß sich die Möglichkeit ergibt, unabhängig vom Schwingungszustand des Oszillators jeweils den entgegengesetzten Schwingungszustand herbeizuführen.

Gemäß der Erfindung kann die zusätzliche zweite Elektrode durch ein leitfähiges Gehäuse des Schalters gebildet werden. Es besteht aber auch die vorteilhafte Möglichkeit, die zusätzliche zweite Elektrode als flache Ringelektrode auszubilden, welche die Sensorelektrode längs ihres Umfangs in geringem Abstand umgibt, wobei es besonders vorteilhaft ist, wenn die Sensorelektrode und die zusätzliche zweite Elektrode durch voneinander isolierte Bereiche einer auf einem gemeinsamen plattenförmigen Träger aufgebrachten Metallschicht gebildet sind. In diesem Fall kann nämlich die zusätzliche zweite Elektrode praktisch ohne jeden zusätzlichen Fertigungsaufwand hergestellt werden, da die auf einem Träger vorgesehene, insbesondere aufkaschierte Metallschicht ohnehin durch Ätzen in die für die Sensorelektrode gewünschte Form gebracht werden kann, wobei dann im Zuge des ohnehin erforderlichen Ätzvorganges gleichzeitig auch die zusätzliche zweite Elektrode hergestellt werden kann.

Gemäß einer abgewandelten bevorzugten Ausführungsform ist auf der von der Sensorfläche abgewandten Rückseite der plattenförmigen Sensorelektrode erfindungsgemäß eine dritte Elektrode in Form einer Ringelektrode angeordnet, die zusammen mit der Sensorelektrode eine Stabilisierungskapazität in einem Gegenkopplungszweig des Oszillators bildet. Bei dieser Ausgestaltung ist dann die mit der Prüfimpulsquelle verbundene zweite Elektrode vorzugsweise als zweite Ringelektrode auf der von der plattenförmigen Sensorelektrode abgewandten Seite der ersten Ringelektrode ausgebildet. Die durch den Einsatz der dritten Elektrode erhaltene Stabilisierungskapazität dient in vorteilhafter Weise zur Kompensation der temperaturabhängigen Drift, der Dielektrizitätskonstante eines an die Sensorelektrode angrenzenden Kunststoffmaterials, beispielsweise eines aus Kunststoff bestehenden Schaltergehäuses oder einer Kunststoffkappe zum Verschließen des vorderen Endes eines metallischen Schaltergehäuses, und zwar in dem Sinne, daß eine temperaturabhängige Drift der Eingangskapazität des Schalters durch eine gleichsinnige temperaturabhängige Änderung der Kapazität im Gegenkopplungszweig kompensiert wird.

Weitere Einzelheiten und Vorteile der Erfindung werden nachstehend anhand von Zeichnungen noch näher erläutert. Es zeigen:
- Fig. 1: ein Schaltbild einer bevorzugten Ausführungsform eines kapazitiven Näherungsschalters gemäß der Erfindung - teilweise in Form eines Blockschaltbildes;
- Fig. 2: eine bevorzugte Ausführungsform einer Elektrodenanordnung für einen Näherungsschalter gemäß Fig. 1 und
- Fig. 3: eine Detaildarstellung einer weiteren bevorzugten Elektrodenanordnung.

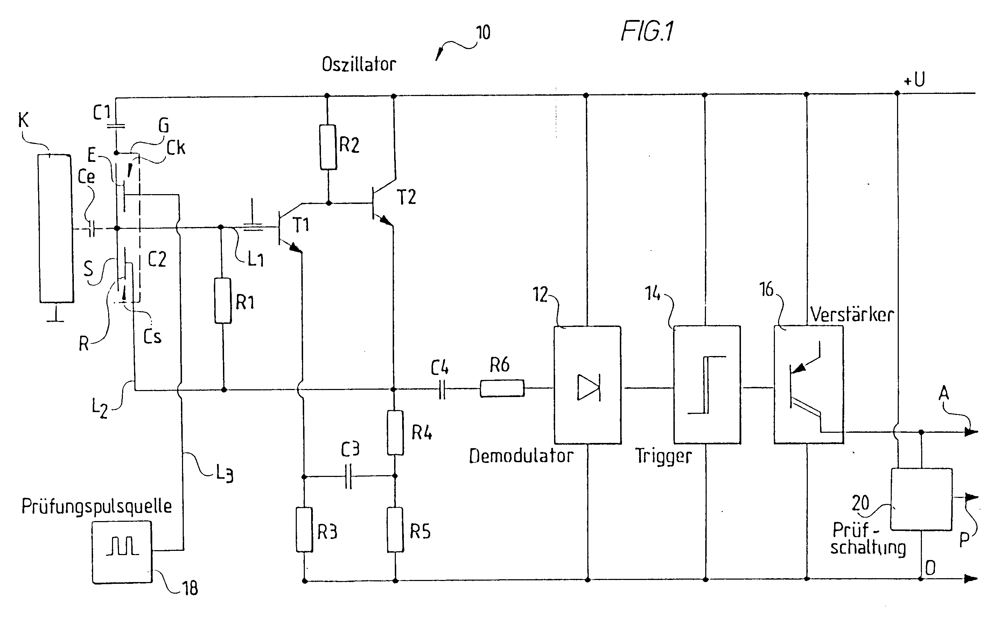

Im einzelnen zeigt Fig. 1 einen erfindungsgemäßen Näherungsschalter mit einem Eingangskreis in Form eines RC-Oszillators 10, welcher zwei Transistoren T1, T2, fünf Widerstände R1 bis R5 und zwei Kondensatoren C1 und C3 sowie eine Sensorelektrode S umfaßt, die kapazitiv mit zwei weiteren Elektroden E und R gekoppelt ist.

Bei dem betrachteten Oszillator bildet der Transistor T1 den Oszillatorverstärker bzw. -transistor, welcher das an seiner Basis anliegende Signal verstärkt und an seinem Kollektor ein Ausgangssignal liefert, welches mit Hilfe des als Impedanzwandler dienenden zweiten Transistors T2 ausgekoppelt wird, an dessen Emitter das verstärkte und invertierte, hochfrequente Oszillatorausgangssignal zur Verfügung steht. Dieses Signal wird mit Hilfe eines Demodulators 12 demoduliert bzw. gleichgerichtet, und das demodulierte Signal wird dann einer Triggerschaltung 14 zugeführt, welche in bekannter Weise mit vorgegebenen Schaltquellen arbeitet. Das Ausgangssignal der Triggerschaltung 14 wird dann im allgemeinen noch mit Hilfe eines Verstärkers 16 verstärkt, so daß das verstärkte Ausgangssignal der Triggerstufe 14 schließlich am Ausgang A des Verstärkers 16 zur Verfügung steht.

Das verstärkte und invertierte Oszillatorausgangssignal wird außerdem einem aus den Widerständen R4 und R5 gebildeten Spannungsteiler zugeführt, der die Höhe des über den Kondensator C3 auf den Emitter des Transistors T1 rückgekoppelten Signals bestimmt. Dabei ist der Arbeitspunkt des Transistors T1 durch die Widerstände R2 und R3 festgelegt. Das über den Kondensator C3 rückgekoppelte Signal ist aufgrund des beschriebenen Schaltungsaufbaus stets ein Mitkopplungssignal.

Das Oszillatorausgangssignal wird vom Emitter des Transistors T2 über den Widerstand R1 auf die Basis des Oszillatortransistors T1 zurückgekoppelt. Dabei liegt parallel zu dem Widerstand R1 eine Stabilisierungskapazität Cs, welche durch die Sensorelektrode S und die weitere Elektrode R gebildet wird. Die Stabilisierungskapazität dient dabei, wie eingangs erläutert, der Kompensation einer temperaturabhängigen Drift der Dielektrizitätskonstante eines an die Sensorelektrode S angrenzenden Kunststoffmaterials.

Der Schwingungszustand des Oszillators 10 wird bei der betrachteten Schaltung durch die Größe der über die Sensorelektrode S an die Basis des Transistors T1 angekoppelten Eingangskapazität Ce bestimmt, welche die Phasenlage des über den RC-Kreis R1, Cs auf die Basis des Transistors T1 zurückgekoppelten Signals in der Weise beeinflußt, daß sich je nach Größe der Eingangskapazität Ce eine Mitkopplung oder eine Gegenkopplung ergibt und damit eine Erhöhung der Schwingungsamplitude des Oszillators bzw. ein Anschwingen desselben oder eine Verringerung der Schwingungsamplitude des Oszillators bzw. ein Abreißen der Oszillatorschwingung.

Der Kondensator C1 dient der Kopplung der Oszillatorschaltung 10 mit einem beim Ausführungsbeispiel metallischen Gehäuse G des Näherungsschalters. Durch die Ankopplung des Gehäuses G über den Kondensator C1 wird die Sensorelektrode S gegen seitliche Einflüße abgeschirmt, so daß die Eingangskapazität im wesentlichen nur noch vom Abstand und von den Materialeigenschaften eines zu erfassenden Körpers K vor der Sensorelektrode S bestimmt wird.

Gemäß der Erfindung ist ergänzend eine Prüfimpulsquelle 18 vorgesehen, welche in an sich bekannter Weise ausgebildet sein kann und welche über eine durch die zusätzliche Elektrode E und die Sensorelektrode S gebildete Koppelkapazität Ck direkt an die Basis des Oszillatortransistors T1 angekoppelt ist. Die Prüfimpulse aus der Prüfimpulsquelle 18 werden daher dem über den RC-Kreis R1, Cs rückgekoppelten Signal an der Basis des Transistors T1 überlagert und führen damit letztlich zu einer entsprechenden Änderung des Triggerausgangssignals bzw. des Signals am Ausgang A der Schaltung, wo die durch die Prüfimpulse verursachten typischerweise sehr kurzen Signaländerungen mit Hilfe einer Prüfschaltung 20 erfaßt werden, die in konventioneller Weise, zum Beispiel gemäß der eingangs erwähnten DE-OS 33 27 188, ausgebildet sein kann und an ihrem Ausgang P ein Signal liefert, welches eine Funktionsstörung des Näherungsschalters anzeigt, wenn innerhalb eines vorgegebenen Zeitintervalls, welches dem zeitlichen Abstand der Prüfimpulse entspricht, keine Pegeländerung am Ausgang der Triggerstufe bzw. des Verstärkers auftritt.

Der betrachtete Näherungsschalter gemäß Fig. 1 arbeitet wie folgt:

Es soll angenommen werden, daß der zu erfassende Körper K zunächst relativ weit von der Sensorfläche des Näherungsschalters entfernt ist. In diesem Fall ist die Eingangskapazität Ce relativ klein. Dabei hat sich am Näherungsschalter ein stationärer Zustand eingestellt, bei dem der Transistor T2 so weit aufgesteuert ist, daß sich ein durch die Widerstände R1 bis R5 definierter Arbeitspunkt einstellt. Der RC-Oszillator 10 schwingt zu diesem Zeitpunkt nicht, da Wechselsignale an der Basis des Oszillator-Transistors T1 nur mit einer Verstärkung < 1 verstärkt werden.

Wird nun der zu erfassende Körper K näher an die Sensorelektrode S heranbewegt, dann wird das über den Widerstand R1 an der Basis des Transistors T1 anliegende Rückkopplungssignal, welches zunächst im Sinne einer Gegenkopplung wirkt, durch die Änderung der wirksamen Eingangskapazität Ce in der Phase gedreht, bis sich eine Mitkopplung und damit eine Kreisverstärkung > 1 ergibt und der Oszillator anschwingt, wobei der für das Anschwingen erforderliche Impuls aus dem Rauschfeld vor der Sensorelektrode S bzw. aufgrund des Widerstandsrauschens erhalten wird. Wenn der RC-Oszillator 10 angesprungen ist, erfolgt die Mitkopplung des verstärkten Ausgangssignals des Transistors T2 über den Kondensator C3, wobei das Verhältnis der Widerstände R5 und R4 die Höhe der mitgekoppelten Spannung bestimmt.

Wenn der Körper K geerdet ist, wie dies in Fig. 1 angedeutet ist, ergibt sich in bekannter Weise der Vorteil, daß sich die zu sensierende variable Eingangskapazität Ce bei gleichem Abstand des zu erfassenden Körpers K nahezu verdoppelt, so daß sich auch der Schaltabstand des Näherungsschalters annähernd verdoppelt, und zwar unter der Voraussetzung, daß es sich bei dem Körper K um einen Metallkörper bzw. einen Körper aus gut leitfähigem Material handelt. Prinzipiell kann der betrachtete Näherungsschalter aber auch Körper aus einem isolierenden Material erfassen.

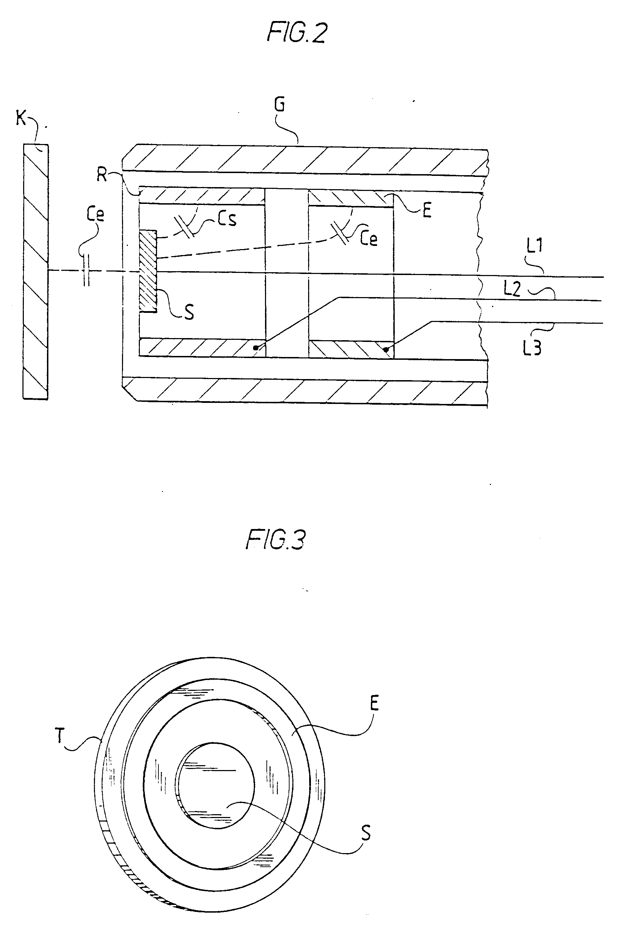

Fig. 2 zeigt eine bevorzugte Art der Anordnung der drei Elektroden S, R und E eines Näherungsschalters gemäß der Erfindung. Man erkennt, daß die Elektrode R, welche zusammen mit der plattenförmigen Sensorelektrode S die Stabilisierungskapazität Cs bildet, als - in der Praxis relativ kurze - zylinderförmige Ringelektrode ausgebildet ist, die unmittelbar hinter der Sensorelektrode S innerhalb des Gehäuses G angeordnet ist, und mit ihrem vorderen - in Fig. 2 linken - die Sensorelektrode S umgibt. In axialer Richtung hinter der Elektrode R ist die Elektrode E angeordnet, welche ebenfalls als zylindrische Ringelektrode ausgebildet ist und zusammen mit der Sensorelektrode S die Koppelkapazität Ck für das Einkoppeln der Prüfimpulse bildet. Die Anschlußleitungen für die Elektroden S, R und E sind in Fig. 2 mit den Bezugszeichen L1, L2 bzw. L3 bezeichnet. Die entsprechenden Leitungen sind in Fig. 1 mit denselben Bezugszeichen bezeichnet, wobei für die zur Basis des Transistors T1 führende Leitung L1 in üblicher Weise eine Abschirmung angedeutet ist.

In weiterer Ausgestaltung der Erfindung besteht gemäß Fig. 3 der Zeichnung die Möglichkeit, die Sensorelektrode S und die weitere Elektrode E an einem gemeinsamen plattenförmigen Träger T anzubringen. Typischerweise besteht der Träger T aus dem üblichen Leiterplattenmaterial, welches auf seiner einen Seite zunächst mit einer durchgehenden Metallschicht versehen ist, aus der dann durch Ätzen unter Anwendung der üblichen Photoätztechnik die Sensorelektrode S und die weitere Elektrode E herausgearbeitet werden. Wenn die Prüfimpulse direkt an das Gehäuse angelegt werden, dann kann in entsprechender Weise auch die zu der Stabilisierungskapazität Cs gehörende Elektrode R gemeinsam mit der Sensorelektrode S auf einem einzigen Träger T ausgebildet werden.

Aus der vorstehenden Beschreibung wird deutlich, daß erfindungsgemäß eine hohe Fehlersicherheit des Näherungsschalters erreichbar ist, da die Überwachung unmittelbar am Schaltereingang bzw. an der Sensorelektrode beginnt, wobei nicht nur die einwandfreie Funktion des Oszillatorverstärkers bzw. des Oszillatortransistors mit überwacht wird, sondern auch noch die einwandfreie Verbindung zwischen der Sensorelektrode und dem Steuereingang des Verstärkers. Weiterhin wird aus der Beschreibung deutlich, daß für die körperliche Realisierung der verschiedenen Elektroden eine Reihe von Möglichkeiten besteht, wobei speziell die konzentrische Elektrodenanordnung auf einer Leiterplatte besonders einfach und preiswert realisiert werden kann.

## Patentansprüche

1. Selbstprüfender Näherungsschalter mit einem Oszillator, der einen mit dem Eingang des Oszillatorverstärkers verbundenen Sensor umfaßt und der durch Annäherung eines Gegenstandes an seine Sensorfläche beeinflußbar ist, mit einem dem Oszillator nachgeschalteten Demodulator und einer Triggerstufe, mit einer kapazitiv an den Oszillator angekoppelten Prüfimpulsquelle zur Erzeugung von Prüfimpulsen, deren Amplitude ausreichend hoch ist, um bei mindestens einem Schaltzustand der Triggerstufe ein Kippen derselben in den anderen ihrer beiden Schaltzustände herbeizuführen, und mit einer auf die in Abhängigkeit von den Prüfimpulsen auftretenden Pegeländerungen des Ausgangssignals der Triggerstufe ansprechenden, der Erzeugung eines Prüfausgangssignals dienenden Prüfschaltung,
**dadurch gekennzeichnet,** daß der Oszillator als kapazitiv beinflußbarer Oszillator ausgebildet ist, wobei der Sensor eine der Sensorfläche zugewandte Sensorelektrode (S) umfasst, die mit dem Eingang des Oszillatorverstärkers verbunden ist, daß die Prüfimpulsquelle (18) mit einer zusätzlichen zweiten Elektrode (E) verbunden ist, die in unmittelbarer Nähe der Sensorelektrode (S) angeordnet ist, und daß das Einkoppeln der mit Hilfe der Prüfimpulsquelle (18) erzeugten Prüfimpulse über die zweite Elektrode (E) auf die Sensorelektrode (S) erfolgt.

2. Näherungsschalter nach Anspruch 1, dadurch gekennzeichnet, daß der Oszillatorverstärker ein Transistor ist und daß die Einkoppelung der Prüfimpulse an der Basis dieses Transistors (T1) erfolgt.

3. Näherungsschalter nach Anspruch 1 oder 2, dadurch gekennzeichnet, daß die zusätzliche zweite Elektrode durch ein leitfähiges Gehäuse (G) des Schalters gebildet ist.

4. Näherungsschalter nach Anspruch 1, dadurch gekennzeichnet, daß die zusätzliche zweite Elektrode (E) als flache Ringelektrode ausgebildet ist, welche die Sensorelektrode (S) längs ihres Umfangs in geringem Abstand umgibt.

5. Näherungsschalter nach Anspruch 4, dadurch gekennzeichnet, daß die Sensorelektrode (S) und die zusätzliche zweite Elektrode (E) durch von einander isolierte Bereiche einer auf einen gemeinsamen plattenförmigen Träger (T) aufgebrachten Metallschicht gebildet sind.

6. Näherungsschalter nach Anspruch 4, dadurch gekennzeichnet, daß auf der von der Sensorfläche abgewandten Rückseite der plattenförmigen Sensorelektrode (S) eine dritte Elektrode in Form einer Ringelektrode (R) angeordnet ist, die zusammen mit der Sensorelektrode (S) eine Stabilisierungskapazität in einem Gegenkopplungszweig des Oszillators bildet.

7. Näherungsschalter nach Anspruch 6, dadurch gekennzeichnet, daß die mit der Prüfimpulsquelle (18) verbundene zweite Elektrode (E) als zweite Ringelektrode auf der von der plattenförmigen Sensorelektrode (S) abgewandten Seite der ersten Ringelektrode (R) ausgebildet ist.

## Claims

1. Self-checking proximity switch with an oscillator comprising a sensor connected to the input of the oscillator amplifier, said oscillator being influenceable by the approach of an object towards its sensor surface, a demodulator connected to the output of the oscillator and a trigger stage, a test pulse source capacitively coupled to the oscillator for generating test pulses having an amplitude sufficiently high to cause the trigger stage, in at least one switching state thereof, to switch over into the other of its two switching states, and a test circuit responding to the alterations in the level of the output signal of the trigger stage occurring as a function of the test pulses, and serving to generate a test output signal, characterized in that the oscillator is designed as a capacitively influenceable oscillator, wherein the sensor comprises a sensor electrode (S) facing the sensor surface, said sensor electrode being connected to the input of the oscillator amplifier, that the test pulse source (18) is connected to an additional, second electrode (E) arranged in the immediate vicinity of the sensor electrode (S), and that the test pulses generated with the aid of the test pulse source (18) are coupled in via the second electrode (E) onto the sensor electrode (S).

2. Proximity switch as defined in claim 1, characterized in that the oscillator amplifier is a transistor and that the test pulses are coupled in at the base of this transistor (T1).

3. Proximity switch as defined in claim 1 or 2, characterized in that the additional, second electrode is formed by a conductive housing (G) of the switch.

4. Proximity switch as defined in claim 1, characterized in that the additional, second electrode (E) is designed as a flat ring electrode surrounding the sensor electrode (S) around its circumference at a slight distance therefrom.

5. Proximity switch as defined in claim 4, characterized in that the sensor electrode (S) and the additional, second electrode (E) are formed by regions of a metal layer applied to a common plate-like carrier (T), said regions being isolated from one another.

6. Proximity switch as defined in claim 4, characterized in that a third electrode in the form of a ring electrode (R) is arranged on the rear side of the plate-like sensor electrode (S) facing away from the sensor surface, said third electrode and said sensor electrode (S) together forming a stabilizing capacitance in a countercoupling branch of the oscillator.

7. Proximity switch as defined in claim 6, characterized in that the second electrode (E) connected to the test pulse source (18) is designed as second ring electrode on the side of the first ring electrode (R) facing away from the plate-like sensor electrode (S).

## Revendications

1. Interrupteur de proximité autocontrôlé comportant un oscillateur, qui comprend un capteur relié à l'entrée de l'amplificateur de l'oscillateur et qui peut être influencé sous l'effet du rapprochement d'un objet en direction de la surface de détection, et comportant un démodulateur branché en aval de l'oscillateur, et un étage déclencheur, une source d'impulsions de contrôle couplée de façon capacitive à l'agitateur servant à produire les impulsions de contrôle, dont l'amplitude est suffisamment élevée pour réaliser, lorsque l'étage déclencheur est au moins dans un état de commutation, un basculement de ce dernier dans l'autre de ses deux états de commutation, et un circuit de contrôle, qui répond aux variations du niveau du signal de sortie de l'étage déclencheur, qui apparaissent en fonction des impulsions de contrôle, et qui sert à produire un signal de sortie de contrôle, caractérisé par le fait que l'oscillateur est agencé sous la forme d'un oscillateur pouvant être influencé de façon capacitive, le capteur comprenant une électrode (S) tournée vers la surface de détection et qui est reliée à l'entrée de l'amplificateur de l'oscillateur, que la source d'impulsions de contrôle (18) est reliée à une seconde électrode supplémentaire (E), qui est disposée à proximité directe de l'électrode (S) du capteur et que le couplage des impulsions de contrôle produites au moyen de la source d'impulsions de contrôle (18) à l'électrode (S) du capteur s'effectue par l'intermédiaire de la seconde électrode (E).

2. Interrupteur de proximité selon la revendication 1, caractérisé en ce que l'amplificateur de l'oscillateur est un transistor et que l'injection des impulsions de contrôle s'effectue au niveau de la base de ce transistor (T1).

3. Interrupteur de proximité selon la revendication 1 ou 2, caractérisé en ce que la seconde électrode supplémentaire est formée par un boîtier conducteur (G) de l'interrupteur.

4. Interrupteur de proximité selon la revendication 1, caractérisé en ce que la seconde électrode supplémentaire (E) est agencée sous la forme d'une électrode annulaire plate, qui entoure à une faible distance l'électrode (S) du capteur, le long de son pourtour.

5. Interrupteur de proximité selon la revendication 4, caractérisé en ce que l'électrode (S) du capteur et la seconde électrode supplémentaire (E) sont formées par des régions, isolées l'une de l'autre, d'une couche métallique déposée sur un support commun en forme de plaque (T).

6. Interrupteur de proximité selon la revendication 4, caractérisé en ce que sur la face arrière, tournée à l'opposé de la surface du capteur, de l'électrode en forme de plaque (S) du capteur est disposée une troisième électrode se présentant sous la forme d'une électrode annulaire (R) et qui forme, conjointement avec l'électrode (S) du capteur, une capacité de stabilisation dans une branche de contre-réaction de l'oscillateur.

7. Interrupteur de proximité selon la revendication 6, caractérisé en ce que la seconde électrode (E) reliée à la source d'impulsions de contrôle (18) est réalisée sous la forme d'une seconde électrode annulaire sur le côté de la première électrode annulaire (R), tourné à l'opposé de l'électrode en forme de plaque (S) du capteur.
